# EUROPEAN PATENT APPLICATION

(11) **EP 1 860 418 A1**
(43) Date of publication of application: **28.11.2007**
(21) Application number: 06010606.9
(22) Date of filing: 23.05.2006
(51) Int. Cl.: G01L 19/00, B81B 7/02, H01G 7/00

(54) **A method for fabricating a pressure sensor using SOI wafers**

(71) Applicant: Sensirion AG, 8712 Stäfa (CH)
(72) Inventor: Sunier, Robert, 8046 Zürich (CH); Streiff, Matthias, 8006 Zürich (CH); Mayer, Felix, 8712 Stäfa (CH); Bühler, Johannes, 8610 Uster (CH)
(74) Representative: Blum, Rudolf Emil

(57) **Abstract**

A pressure sensor is manufactured by joining two wafers (1a, 14), the first wafer comprising CMOS circuitry (2) and the second being an SOI wafer. A recess is formed in the top material layer of the first wafer (1a), which is covered by the silicon layer (17) of the second wafer (14) to form a cavity (18). Part or all of the substrate (15) of the second wafer (14) is removed to forming a membrane from the silicon layer (17). Alternatively, the cavity can be formed in the second wafer (14). The second wafer (14) is electrically connected to the circuitry (2) on the first wafer (1a). This design allows to use standard CMOS processes for integrating circuitry on the first wafer (1a).

## Description

The present invention relates to a method for fabricating a pressure sensor using a first and a second wafer, where the first wafer has circuitry integrated thereon and the second wafer comprises a handle substrate, a silicon layer and an insulation layer between the handle substrate and the silicon layer.

It has been known to manufacture a pressure sensor by joining a first wafer and a second wafer, where the first wafer has a recess that is covered by the second wafer. The second waver is an SOI (Silicon On Insulator) wafer, i.e. a wafer having a comparatively thick handle substrate of silicon, with a thin insulating layer arranged on top of the handle substrate and a thin silicon layer arranged over the insulating layer. The handle substrate is removed for forming a deformable membrane over the recess. The recess reaches into the silicon substrate of the first wafer. Such a design is poorly compatible with standard CMOS manufacturing processes and requires a number of additional, non-standard manufacturing steps that render it expensive.

Hence, it is an object of the present invention to provide a method that has higher compatibility with standard CMOS processes or bipolar processes.

This object is achieved by the method and sensor according to the independent claims.

Hence, according to the invention, the second wafer is electrically connected to the circuitry integrated on the first wafer, which e.g. allows standard CMOS circuitry on the first wafer to cooperate with one or more sensor elements formed by the second wafer.

In an advantageous embodiment, the second wafer is applied as a whole to the first wafer. Alternatively, the second wafer can first be cut into individual chips, which are then applied to the first wafer.

In one advantageous embodiment, the second wafer comprises a cavity closed by the membrane. This obviates the need to form any recess in the substrate of the first wafer, thereby further improving compatibility with standard CMOS processes or bipolar processes.

Similarly, in a second advantageous embodiment, the cavity is formed by a recess in the first wafer, but the recess only extends through a material layers (or several material layers) applied to the base substrate of the first wafer. The second wafer is mounted to the first wafer in such a manner that the silicon layer of the second wafer forms the deformable membrane over the recess. Hence, the recess can be formed by locally omitting or removing one or more material layers from the base substrate, a procedure which is again compatible with standard CMOS manufacturing processes. The material layer(s) can e.g. correspond to one or more of the layers typically applied in standard CMOS manufacturing processes, such as silicon oxide or silicon nitride layers, polysilicon layers or metal layers.

The term "pressure sensor" as used herein designates any type of sensor measuring a parameter that is equal to or derived from the pressure of a fluid. In particular, the term designates relative as well as absolute pressure sensors, it also covers static as well as dynamic pressure sensors, an important example of a dynamic pressure sensor being a microphone for detecting pressure oscillations in the range of some Hertz to some MHz. Typical examples of applications of such sensors are e.g. in scientific instrumentation, meteorology, altitude measurement, sound recording, etc.

Further advantageous embodiments and applications of the invention are given in the dependent claims as well as in the following description, which description makes reference to the attached figures, wherein:
Fig. 1 shows a schematic sectional view of a pressure sensor with circuitry and recess in the first wafer,
Fig. 2 depicts a first step in one embodiment of the present invention,
Fig. 3 depicts a second step in one embodiment of the present invention,
Fig. 4 depicts a third step in one embodiment of the present invention,
Fig. 5 depicts a fourth step in one embodiment of the present invention,
Fig. 6 depicts a fifth step in one embodiment of the present invention,
Fig. 7 is a legend of the hatching patterns used in Figs. 1 - 6 and 8ff,
Fig. 8 shows a first step of a second embodiment of the present invention,
Fig. 9 shows a second step of the second embodiment of the present invention,
Fig. 10 shows a first step of a third embodiment of the present invention,
Fig. 11 shows a second step of the third embodiment of the present invention,
Fig. 12 shows a fourth embodiment of the present invention,
Fig. 13 shows a fifth embodiment of the present invention is an intermediate manufacturing step, and
Fig. 14 shows the embodiment of Fig. 13 after assembly.

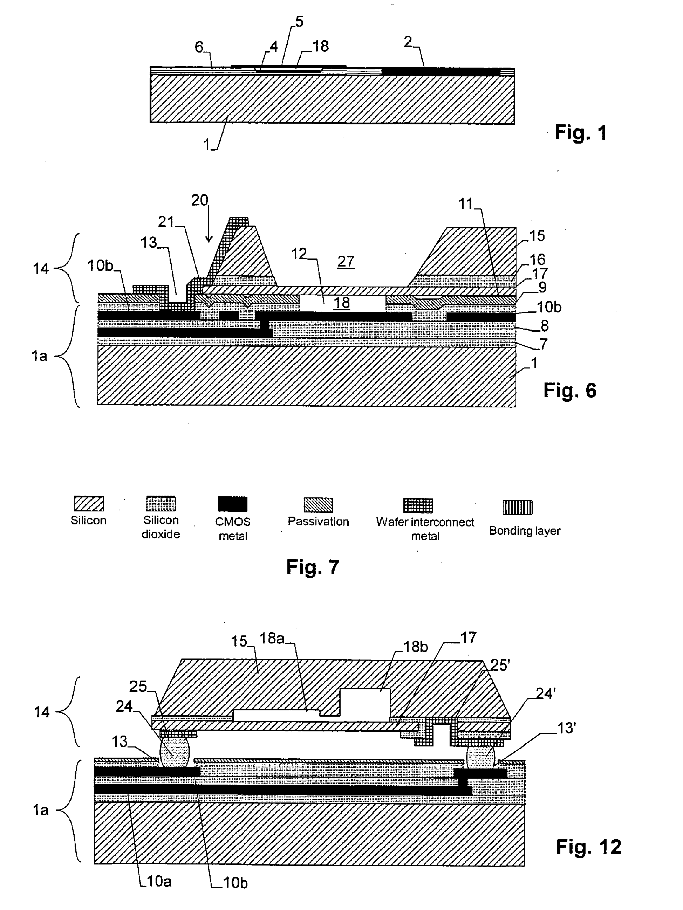

The basic design of an embodiment of the pressure sensor according to the present invention is shown in Fig. 1. The sensor comprises a base substrate 1 of silicon with circuitry 2 integrated thereon. Circuitry 2 may e.g. comprise amplifiers, analog digital converters, analog and/or digital processing circuitry, interface circuits etc. Circuitry 2 can be of very simple design, e.g. comprising only a small number of transistors, or it can be complex and have a large number of transistors. Circuitry 2 is advantageously manufactured using a conventional CMOS manufacturing process.

Further, the sensor of Fig. 1 comprises a cavity 18 formed by a recess 4 covered by a membrane 5. In the shown embodiment, recess 4 is arranged in material layers 6 deposited on top of base substrate 1, namely the layers that have been applied to base substrate 1 in the course of the CMOS process used for creating circuitry 2.

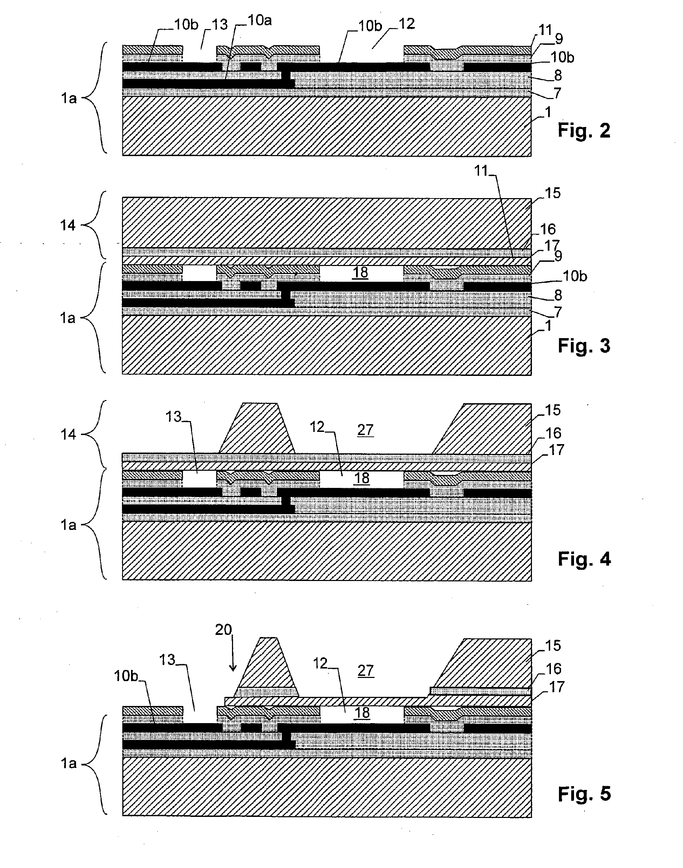

Figs. 2 to 6 illustrate the steps for a method to manufacture a pressure sensor. As described in more detail below, they substantially involve the formation of CMOS circuitry and a recess in a first wafer consisting of the base substrate and the material layers deposited thereon. The first wafer is subsequently joined to a second wafer, which is an SOI wafer having a handle substrate of silicon (on any other suitable material) with an insulating layer and a silicon layer deposited thereon. Finally, the second wafer is machined to form a membrane.

In a first step, CMOS circuitry 2 is applied to base substrate 1 of first wafer 1a using a conventional CMOS manufacturing process. This process comprises the application of various material layers, such as silicon dioxide layers 7, 8, 9 with polisilicon and/or metal layers 10a, 10b arranged therebetween. Typically, the layers are topped with a passivation layer 11 comprising silicon dioxide and/or silicon nitride.

As can be seen in Fig. 2, a recess 12 is formed on the top surface (i.e. the surface receiving the circuitry 2). Recess 12 extends through part or all of the material layers 7 - 11, but not into base substrate
1. In the embodiment shown in Fig. 2, recess 12 extends through passivation layer 11 and topmost silicon dioxide layer 9. Recess 12 can be formed either by locally removing these layers 9, 11 using etching techniques or by locally omitting the layers 9, 11 using masking techniques. Recess 12 reaches down to topmost metal layer 10b. Forming this type of recess is part of the conventional CMOS manufacturing process and is e.g. used for creating contact windows.

In fact, a contact window 13 providing access to topmost metal layer 10b is also formed at a distance from recess 12.

In a next step, as shown in Fig. 3, the second wafer 14 is applied to first wafer 1a. As mentioned, second wafer 14 comprises a handle substrate 15, advantageously of silicon, which carries an insulating layer 16 e.g. of silicon dioxide and a strongly doped silicon layer 17. Optionally, silicon layer 17 can be topped with a second dielectric layer for insulation and passivation.

Second wafer 14 is bonded to first wafer 1a in such a way that silicon layer 17 is facing first wafer 1a.

Now, and as shown in Fig. 4, part or all of handle substrate 15 is removed using a chemical etching process or a combination of mechanical milling and subsequent etching. In the embodiment of Fig. 4, a recess 27 is formed in handle substrate 15. Recess 27 reaches down to insulating layer 16. In addition to this, handle layer 15 is also removed above contact window 13.

In a next step, as shown in Fig. 5, insulating layer 16 is removed in the area of recess 18 as well as above contact window 13, which leaves silicon layer 17 as a flexible membrane extending over and closing recess 12, thereby forming a cavity 18. Such a pure silicon membrane has high stability, predictable elastic properties and is substantially free of inherent stress.

Now silicon layer 17 is removed on top of contact window 13 thereby creating an access to topmost metal layer 10b. Contact window 13 is located at an edge 20 of second wafer 14.

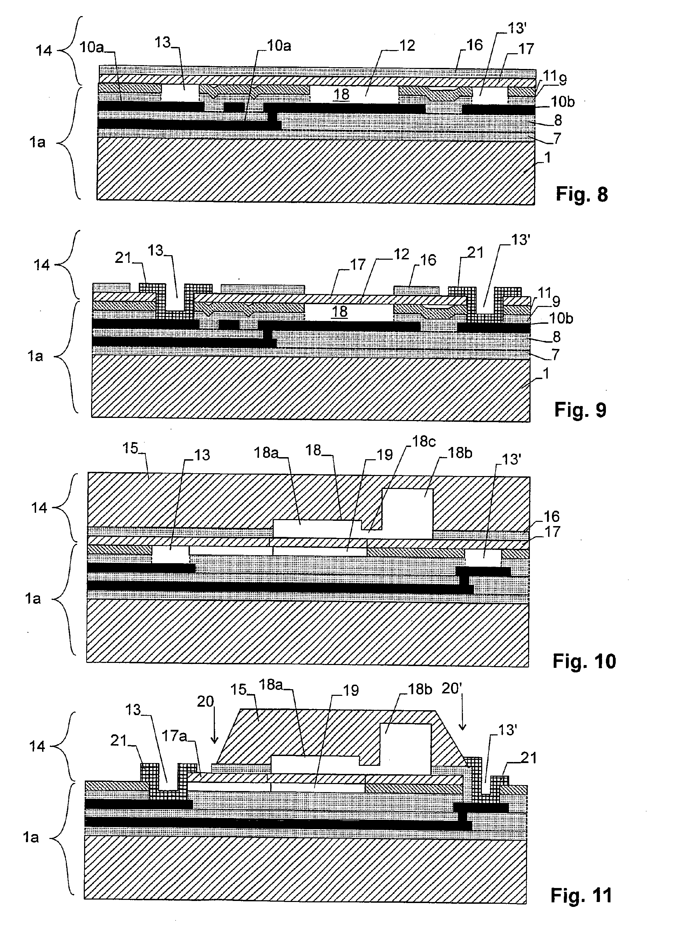

As shown in Fig. 6, a wafer interconnect layer 21 is now applied to contact window 13 in first wafer 1a and to the edge 20 of second wafer 14. It generates an electrical contact between topmost metal layer 10b in the area of contact window 13, silicon layer 17 and handle substrate 15.

The resulting device shown in Fig. 6 has a hermetically sealed cavity 18 with a bottom electrode formed by topmost metal layer 10b and a top electrode formed by silicon layer 17. Wafer interconnect metal layer 21 allows to connect metal layer 10b and therefore the top electrode to the circuitry 2 on base substrate 1.

A change of pressure will lead to a deformation of the membrane formed by silicon layer 17 and therefore to a change of electrical capacitance between the two electrodes of cavity 18, which can be measured by circuitry 2.

Figs. 8 and 9 show an alternative embodiment of the present manufacturing process and device. The first steps of this process correspond to the steps shown in Figs. 2 and 3. Now, however, all of handle substrate 15 is removed, as shown in Fig. 8, leaving only insulating layer 16 and silicon layer 17 of second wafer 14.

Subsequently, and as shown in Fig. 9, insulating layer 16 is removed over cavity 18 and contact window 13 as well as over a second contact window 13', and silicon layer 17 is removed over both contact windows 13, 13'. Now, wafer interconnect layer 21 can be applied at both contact windows 13, 13', thereby providing an electric contact between top metal layer 10b and silicon layer 17.

Figs. 10 and 11 show a third embodiment. In this embodiment, the cavity 18 is formed in second wafer 14.

The process again starts with manufacturing circuitry 2 in first wafer 1a. At the same time, two contact windows 13, 13' are formed at the top surface thereof, as well as a recess 19.

In addition to this, second wafer 14 is prepared with a cavity 18 formed by a recess in handle wafer 15 covered by silicon layer 17. Methods for manufacturing such structures are known to the person skilled in the art and need not be described here.

Cavity 18 has a first chamber 18a and a second chamber 18b interconnected by a passage 18c. First chamber 18a has smaller height and smaller volume than second chamber 18b.

Second wafer 14 is bonded to first wafer 1a as shown in Fig. 10, with first chamber 18a being arranged over recess 19.

Now, as shown in Fig. 11, second wafer 14 is structured by removing part of handle substrate 15 such that it forms edges 20, 20', one of which is adjacent to contact window 13'. Insulating layer 16 is removed substantially everywhere except below the remaining part of handle substrate 15. Silicon layer 17 is etched off similarly, but extends at one end 17a to end adjacent to contact window 13. Now, wafer interconnect metal layers 21 are deposited at both contact windows 13, 13', connecting contact window 13 to silicon layer 17 and contact window 13' to handle substrate 15.

Albeit not visible in Fig. 11, recess 19 is laterally open to the environment, thereby exposing one side of the membrane formed by silicon layer 17 to ambient pressure.

In the embodiment of Fig. 11, chamber 18a is a capacitor with one electrode being formed by silicon layer 17 and the other electrode being formed by handle substrate 15. Chamber 18b, which has a much larger volume than chamber 18a, serves to improve the volume to surface ratio of cavity 18, thereby providing improved stability of the absolute pressure therein.

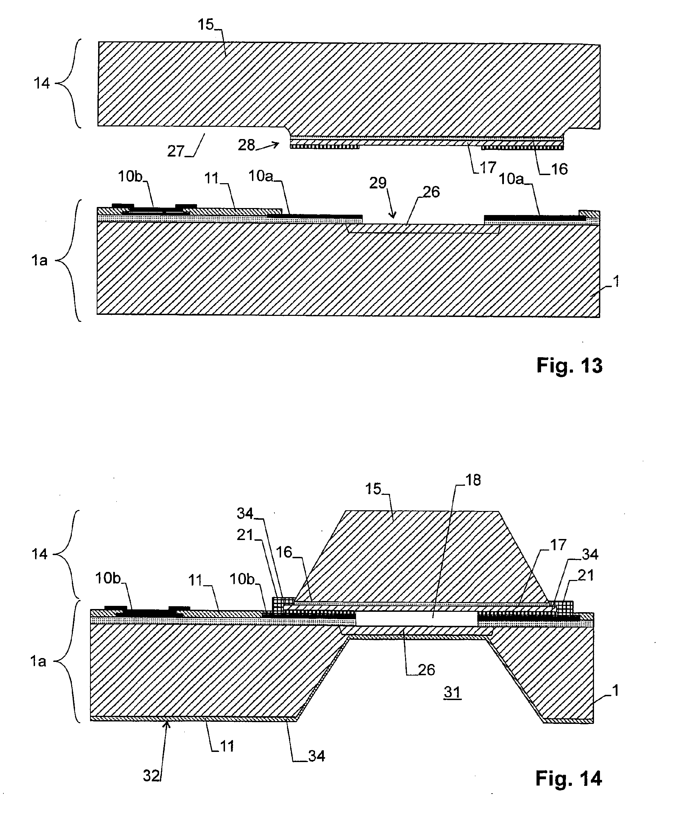

Fig. 12 shows an embodiment of the invention similar to the one of Fig. 11, but using a different method for contacting the two wafers. In the embodiment of Fig. 12, second wafer 14 is joined to first wafer 1a via metal bumps 24, 24'.

For this purpose, two contact windows 13, 13' are formed in first wafer 1a and a metal bump 24, 24' (or a bump of any other suited conducting material) is applied over each of them.

Matching the positions of the metal bumps 24, 24', two metal pads 25, 25' are arranged on second wafer 14, one of them contacting silicon layer 17, the other handle substrate 15. Then, second wafer 14 is placed on first wafer 1a such that the metal pads 25, 25' contact the metal bumps 24, 24'. This step may e.g. take place under elevated pressure or temperature for softening the metal bumps 24, 24', thereby creating reliable, mechanically stable contacts.

Alternatively, the metal bumps 24, 24' can first be applied to second wafer 14.

Instead of using metal bumps 24, 24', other conducting materials for creating suitably conducting connections are known to the person skilled in the art. In particular, anisotropically conducting glues can be used. Ssuch glues contain conducting particles in a nonconducting matrix. When pressing the wafers against each other with the glue therebetween, the particles come into contact with each other and create conducting paths between the wafers.

Instead of applying the second wafer 14 as a whole to the first wafer 1a, it is possible to first cut (or etch) the second wafer into a plurality of individual chips, which then are applied to the first wafer 1a.

Yet another embodiment of the present invention is shown in Figs. 13 and 14.

As shown in Fig. 13, base substrate is first provided with a strongly doped region 26 surrounded by a metal or polysilicon layer 10a. Strongly doped region 26 resides in a recess 29.

A suitable bonding layer 29, which may be a polymeric or metallic film, is affixed to second wafer 14 opposite to the metal or polysilicon layer 10a surrounding strongly doped region 27. Then, top layer 17, insulating layer 16 and part of the underlying handle substrate 15 of second wafer 14 are locally removed to form a recessed region 27, leaving a projecting region 28 opposite to strongly doped region 27.

Subsequently, second wafer 14 is bonded to first wafer 1a in the region of bonding layer 29 by methods known to the person skilled in the art. In this way, a cavity 18 is formed by former recess 29 above strongly doped region 26.

Handle substrate 15 is etched off everywhere except above the remaining top layer 17. Advantageously, patterning is chosen such that top layer 17 extends laterally beyond the remaining handle substrate 15, thereby forming projections 34.

A wafer interconnect layer 21 is then applied to form an electrical connection between the metal layers 10b and top layer 17 as well as substrate 15 of second wafer 14. Wafer interconnect layer 21 encloses the projections 34, thereby providing a stable and reliable connection.

In a next step, anisotropic etching is used to manufacture a recess 31 into base substrate 1 from the side 32 opposite to second wafer 14. Recess 31 reaches all through base substrate 1 to strongly doped region 26. Side 32 of base substrate 1 as well as the surfaces of recess 31 are then covered by a passivation layer 34.

Hence, in this embodiment, strongly doped region 26 of base substrate 1 forms the flexible membrane between cavity 18 and recess 31 that is deformed depending on applied pressure. It forms one of the electrodes of a capacitor, the second electrode being formed by silicon layer 17 of second wafer 14.It must be noted that the embodiment of Figs. 13 and 14 does not require second wafer 14 to be an SOI-wafer. Alternatively, second wafer 14 can be a conventional silicon wafer or a wafer of any other material.

The embodiment of Figs. 13 and 14 has the advantage that the fluid whose pressure is to be measured can be applied to side 32 of first substrate 1a, i.e. to the side opposite to the integrated electronics and contact pads of the device, which makes it easier house the device in such a manner that the CMOS circuitry is protected against adverse environmental influences.

Instead of forming the recess 31 in first wafer 1a, material of first wafer 1a can be removed uniformly for thinning first wafer 1a until it is thin enough to form a flexible membrane closing cavity 18.

In the embodiments shown so far, there were two conducting layers 10a, 10b of metal in first wafer 1a. Depending on the CMOS (or bipolar) process to be used, this number may vary, and/or one or more of the conducting layers can be of silicon. Similarly, the number and composition of the insulating layers may vary.

## Claims

1. A method for fabricating a pressure sensor comprising the steps of
providing a first wafer (1a) comprising integrated circuitry (2) thereon,
providing a second wafer (14), and
mounting said second wafer (14), or a chip prepared from said second wafer, on said first wafer (1a),
said method being **characterized by** the step of
electrically connecting said second wafer (14) to said circuitry (2) on said first wafer (1a).

2. The method of claim 1 wherein said second wafer (14) comprises a handle substrate (15), a silicon layer (17) and an insulating layer (16) between said handle substrate (15) and said silicon layer (17).

3. The method of claim 2 wherein said silicon layer (17) is positioned to form at least part of deformable membrane for sensing a pressure.

4. The method of any of the preceding claims wherein said second wafer (14) comprises a cavity (18) closed by said membrane.

5. The method of the claims 3 and any of the claims 3 or 4 comprising the steps of forming a first electrical contact between said circuitry (2) and said handle substrate (15) and a second electrical contact between said circuitry (2) and said membrane.

6. The method of any of the claims 4 or 5 comprising the step of forming said cavity at least partially by forming a recess in said handle substrate (15).

7. The method of any of the claims 4 to 6 wherein said cavity comprises a first chamber (18a) and a second chamber (18b), the first chamber (18a) having smaller volume and smaller height than the second chamber (18b), wherein said deformable membrane covers said first chamber (18a).

8. The method of any of the preceding claims comprising the step of removing at least part, and in particular all, of said handle substrate (15) of said second wafer (14) after mounting said second wafer (14) on said first wafer (1a).

9. The method of claim 8 comprising the step of removing at least part of said handle substrate (15) at least down to said insulating layer (16).

10. The method of any of the preceding claims comprising the step of mounting said second wafer (14) to said first wafer (1a) with said silicon layer (17) facing said first wafer (1a).

11. The method of any of the preceding claims wherein said first wafer (1a) has a base substrate (1) of silicon with integrated circuitry (2) integrated thereon and at least one material layer (7 - 11) deposited on said base substrate (1), said method comprising the steps of
manufacturing a recess (12) in said first wafer (1a) by locally removing or omitting said material layer (7 - 11) and
mounting said second wafer (14) on said first wafer (1a) in such a manner that said silicon layer (17) of said second wafer (14) forms said membrane over said recess (12).

12. The method of claim 11 wherein said material layer is a silicon oxide, silicon nitride, metal or polisilicon layer.

13. The method of claim 12 wherein said recess is formed over a conducting layer, in particular a metal layer (10b) on said first wafer (1a).

14. The method of any of the claims 12 or 13 wherein said recess (12) does not reach into said base substrate (1).

15. The method of any of the preceding claims comprising the steps of preparing a contact window (13) on said first wafer (1a),
forming or placing an edge (20) of said second wafer (14) at said contact window (13), and
applying a metal layer (21) contacting said contact window (13) to said edge (20).

16. The method of any of the preceding claims comprising the steps of
preparing at least one contact window (13, 13') on said first wafer (1a), and
placing said second wafer (14) on said first wafer (1a) with a conducting material (24) arranged between said second wafer (14) and said contact window (13, 13').

17. The method of any of the preceding claims wherein said second wafer (14) is a SOI wafer with said handle substrate (15) being a silicon substrate.

18. The method of any of the preceding claims wherein said integrated circuitry (2) is manufactured using a CMOS process or a bipolar process.

19. The method of any of the preceding claims further comprising the steps of
forming a cavity (18) between said first and said second wafer,
removing material from said first wafer (1a) from a side (32) opposite to said second wafer (14) with a membrane formed by said first wafer (1a) remaining for closing said cavity (18).

20. The method of claim 19 wherein a passivation layer (34) is applied from said second side (32) to said first wafer.

21. The method of any of the claims 19 or 20 comprising the step of locally etching off part of said second wafer (14),
and in particular wherein second wafer (14) comprises a silicon top layer (17), an insulating layer (16) and a handle substrate (15) with the insulating layer (16) being arranged between said top layer (17) and said handle substrate (15), and, wherein said second wafer is locally etched off thus that top layer (17) extends laterally beyond handle substrate (15), thereby forming projections (34), which projections are then enclosed by a wafer interconnect layer (21).

22. The method of any of the claims 19 to 21 comprising the step of forming a recess (31) in said first wafer from a side (32) opposite to said second wafer (14) into said first wafer (1a), with said membrane remaining between said cavity (18) and said recess (31).
